# EUROPEAN PATENT SPECIFICATION

(11) **EP 2 449 147 B1**
(45) Date of publication and mention of the grant of the patent: **19.10.2016**
(21) Application number: 10732619.1
(22) Date of filing: 29.06.2010
(51) Int. Cl.: C23C 14/06, C23C 14/32, F16J 9/00

(54) **PISTON RING**
KOLBENRING
SEGMENT DE PISTON

(30) Priority: 01.07.2009 BR PI0902339
(43) Date of publication of application: 09.05.2012
(73) Proprietor: Mahle Metal Leve S/A, 13210-877 Jundiaí, SP (BR); MAHLE International GmbH, 70376 Stuttgart (DE)
(72) Inventor: AVELAR ARAÚJO, Juliano, 13208-611 Jundiai SP (BR)
(74) Representative: BRP Renaud & Partner mbB Rechtsanwälte Patentanwälte Steuerberater
(86) International application number: PCT/BR2010/000204
(87) International publication number: WO 2011/000068

(56) References cited:
- WO-A1-2005/121403
- DE-A1- 4 419 713
- US-A1- 2008 095 939
- KURUPPU M L ET AL: "Monolithic and multilayer Cr/CrN, Cr/Cr2N, and Cr2N/CrN coatings on hard and soft substrates" JOURNAL OF VACUUM SCIENCE AND TECHNOLOGY: PART A, AVS /AIP, MELVILLE, NY., US LNKD- DOI:10.1116/1.581202, vol. 16, no. 3, 1 May 1998 (1998-05-01), pages 1949-1955, XP012004060 ISSN: 0734-2101

## Description

The present invention refers to a piston ring, particularly for use in internal combustion engines or gas compressors, having a plurality of sequential coating layers composed of chromium nitride. The resulting ring thereby achieves excellent wear-resistance properties.

### Description of the state of the art

Internal combustion engines that operate according to Otto and Diesel cycles are used to traction-drive the vast majority of automotive vehicles and basically comprise two main parts: a cylinder block (where one or more cylinders and the crankshaft are located), to which one or more cylinder heads are associated. To the crankshaft, pistons and rods are associated.

The space defined between the upper face of the piston, the cylinder wall and the base of the cylinder head corresponds to the combustion chamber, and in Diesel engines, in general, the combustion chamber(s) is(are) defined chiefly by cavity(ies) provided on the head(s) of the piston(s).

Inside the combustion chamber(s), the engine converts the chemical energy produced by combustion of the inflammable mixture (fuel and air) into mechanical energy capable of transmitting movement to the wheels.

In order to assure homogenous combustion and without burning oil and also to avoid the passage of excess gases from the cylinder to the crankcase, it is necessary to use rings to provide good sealing of the gap between the piston and the cylinder wall.

Normally, more modern four-stroke engines use three rings on each piston, two compression rings and one oil ring. The role of the compression rings is to prevent the passage of the combustion gases into the crankcase, whereas the function of the oil ring is to scrape the excess oil from the cylinder wall and return it to the crankcase, controlling the thickness of the 'film' of oil and preventing it from being unduly burned.

Another important function of the rings is to act as a bridge to transmit heat from the piston to the cylinder wall / sleeve, where it is dissipated by way of the cooling system.

As a general rule, the piston rings, chiefly the compression rings, are formed by a metallic base to which there is applied at least a coating layer, which comes into contact with the cylinder wall.

The role of the coating layer is among the most important because it seeks to confer to the ring low sliding attrition properties, superior resistance to spalling, hardness and tenacity. However, many of these properties are antagonic and an increase in one of them means a loss in the performance of another, so the type of coating to be used is chosen based on the function of the engine working profile and on the forces to which the rings will be subjected during their useful life.

A series of sophisticated coatings were proposed by persons skilled in the art, each seeking to increment the desired properties. However, none of the coatings proposed up to now has been efficient in increasing, concomitantly, the internal stress absorption properties, superior hardness and low thickness, which significantly reduces spalling.

A first prior art is represented by North American patent US 5,718,437, which refers to an oil-scraping ring having a coating of Cr₂N monolayer, with a thickness of about 3µm and 30µm.

According to the document, the coating layer of Cr₂N presents a hardness between 1300 HV and 2000 HV and is applied by the process commonly known by persons skilled in the art as 'ion plating'.

A second prior art developed is represented by the Japanese patent case JP9196173, which discloses an invention very similar to the North American patent referred to above, namely an oil-scraping ring having a coating of Cr₂N monolayer, with a width of about 3µm to 30µm.

North American patent US 5,820,131 refers to a piston ring having a coating formed by a single layer of Cr₂N or a mixture of Cr₂N and CrN, with a width of 3µm to 30µm and a percentage of nitrogen, by weight, between 11% and 17%. The coating layer is applied by a process called 'Physical Vapor Deposition' (PVD) process and its hardness oscillates between 1300 HV and 2000 HV.

North American patent US 5,743,536 refers to a piston ring having a coating layer formed by at least a chromium nitride, applied by PVD. The chromium nitride comprises CrN, Cr₂N or a mixture of CrN and Cr₂N, in a single phase. The document also specifies various values of thickness and porosity, besides disclosing various mechanical assays on products having coatings with various end arrangements. According to the patent, the coating presents excellent properties of abrasion resistance, spalling and burning.

Further, North American patent US 5,851,659, from the same family as patent US 5,743,536, discloses a very similar product.

Further, a piston ring is known by the WO 2005/121403 A1 which comprises a multilayer PVD-coating containing a plurality of Cr/CrN (Cr₂N) layers.

Lastly, the last representative prior art can be found in North American patent US 6,631,907, which refers to a piston ring having a coating layer comprised by CrN or Cr₂N, or a mixture of nitrides, applied by PVD. The document also reveals the application of a mixture of CrN with Cr₂N and metallic Cr, and discloses details of percentages by weight of the components.

It must be noted that all the solutions of the state of the art resort to the use of CrN or Cr₂N, in isolation or mixed, to obtain a single layer of coating that has high rates of resistance to abrasion, spalling and burning.

However, there is a limit to this increase, which varies depending on the percentage of CrN or Cr₂N of the nitride layer and on any other elements added. If an even greater increase in these properties is desired, the single-layer nitrided coating is no longer a viable solution, much less innovative.

The piston ring that is the object of the present invention, by presenting an innovative constitution, carries forward the properties presented by the coating layer. For the first time, there is proposed a multilayer coating, composed of a plurality of consecutive nitrided layers, alternating CrN with Cr₂N as majority component.

The result is a coating with the best of the two components, by presenting the desirable properties of each variation of chromium nitride, without potentializing the weak points of each.

The layers of Cr₂N confer the coating superior hardness and wear resistance, at the same time in which the layers of CrN collaborate so that the coating has good ductility rates. The best properties of each compound are thereby potentialized.

The coating now developed confers the piston ring superior wear resistance and, concomitantly, a considerable reduction in internal stress rates, reducing the occurrence of cracks in the coating and the consequent spalling.

### Objectives of the invention

The objective of the present invention is a piston ring, particularly for use in an internal combustion engine or a compressor, having a multiplicity of layers of chromium nitride coating, in the CrN and Cr₂N phases, thus presenting, concomitantly, the antagonic properties of hardness, wear resistance, ductility and reduction of internal stress.

The objective of the present invention is also a piston ring, particularly designed for use in internal combustion engines or compressors, comprising at least a metallic base to which there is applied, by the process of physical vapor deposition, a coating of chromium nitride formed by at least two adjacent layers that have different predominantly chromium nitride phases.

Further, the objective of the present invention is a piston ring, particularly for use in an internal combustion engine or compressor, having a multiplicity of layers of chromium nitride coating, in the CrN and Cr₂N phases, which have lesser thickness compared to the thickness of the coating of the rings of the prior art.

Lastly, the objective of the present invention is the process of applying a multiplicity of layers of chromium nitride coating in the CrN and Cr₂N phases in a metallic piston ring body, in a single application step, by means of the variation in pressure of the nitrogen gas in the process of physical vapor deposition.

### Brief description of the invention

The objectives of the present invention are achieved by a piston ring, particularly devised for use in internal combustion engines or compressors, comprising at least a metallic base to which there is applied, by the process of physical vapor deposition, a coating of chromium nitride that comprises a periodicity, formed by at least two adjacent layers, each layer having predominantly chromium nitride phase different from the adjacent layer.

### Brief description of the drawings

The present invention will now be described in greater detail based on an example of execution represented in the drawings. The figures show:
Figure 1 - is a schematic, cross-sectional view of the piston ring that is the object of the present invention, mounted on the channel of a piston and in attrition with the wall of a cylinder.
Figure 2 - is an expanded metallographic photograph of the cross section of the piston ring that is the object of the present invention, showing the metallic base and the multilayer coating.

### Detailed description of the drawings

The piston ring 1 that is the object of the present invention differs from those currently existing by the innovative and advantageous characteristics of its coating.

Initially, it is notable that the ring 1 is preferably a compression ring for use in an internal combustion engine that operates according to the four-stroke cycle, although it is obvious that the ring can assume various other embodiments, such as an oil-scraping ring, a compression ring of a two-stroke engine, a ring of a piston compressor, or any other embodiment necessary or desirable, provided that its coating bears the characteristics and innovations now defined.

Whatever its preferred constitution, the piston ring that is the object of the present invention comprises at least a metallic base 2 to which there is applied, by the process of physical vapor deposition (PVD), a coating 3 of chromium nitride which, as described ahead, comprises a plurality of layers of chromium nitride 5,5' arranged so as to form at least two periodicities P, where each periodicity P is formed by at least two adjacent layers 5,5'. The adjacent layers 5,5' of each periodicity P have different predominantly chromium nitride phases.

The base 2 is composed of any metallic material suitable for the mission and may have varied cross-section formats depending on the characteristics of the ring 1 and on the working conditions under which it will operate.

Preferably, stainless steel, carbon steel or cast iron is used in the composition of the base 2, of different compositions, however it is obvious that other materials, if necessary or desirable, can replace these. More preferably, the base 2 is composed of steel with 10 to 17% of chrome. It is also possible that the steel used may undergo a nitriding process.

To the base 2 there is applied the coating 3 of chromium nitride which confers the ring 1 properties of superior wear resistance and, concomitantly, a considerable reduction in the internal stress rates, reducing the occurrence of cracks in the coating and the consequent spalling.

Exactly as mentioned above, the coating 3 comprises a plurality of layers of chromium nitride 5,5' arranged so as to form a periodicity P. Hence, the periodicity P comprises at least two adjacent layers 5,5', compulsorily having varied constitution, that is, each having a predominantly chromium nitride phase. Therefore, the coating 3 will have at least four layers 5,5'.

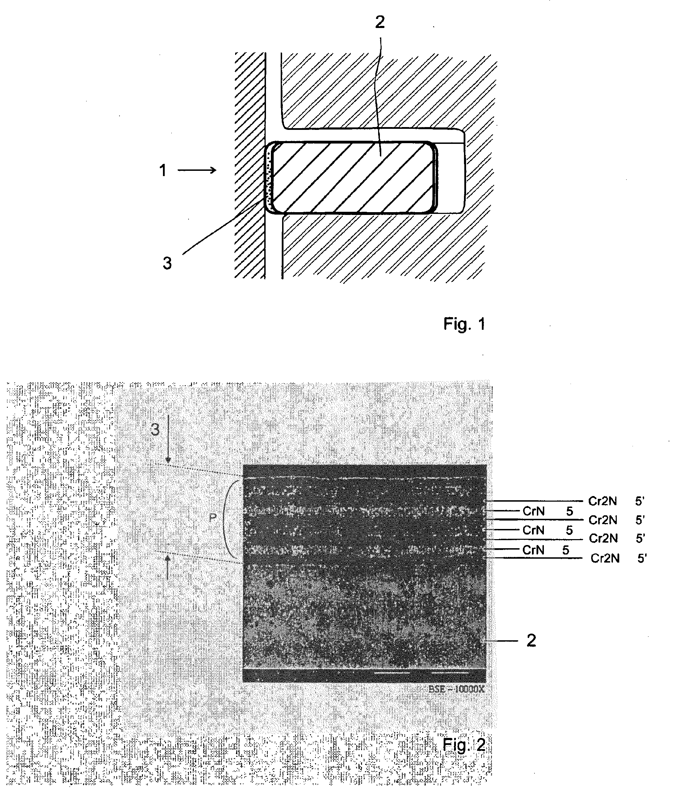

A first layer quality 5 comprises chromium nitride in CrN form or phase (illustrated as lighter layers in figure 2), having a superior ductility as the main mechanical characteristic.

The second layer quality 5' comprises chromium nitride in Cr₂N form or phase (illustrated as darker layers in figure 2), having a superior hardness as the main mechanical characteristic.

It is important to note that we are referring to predominantly chromium nitride phases, that is, the first layer quality 5 is composed predominantly by CrN (although obviously there is a reduced percentage of Cr₂N and/or of other compounds/elements in its composition) whereas the second layer quality 5' is composed predominantly of Cr₂N, although certainly there is a reduced percentage of CrN and/or other compounds/elements in its composition.

In light of the above, it is clear that periodicity P has at least one layer 5 composed predominantly of CrN and one layer 5' composed predominantly of Cr₂N.

Preferably, precisely as illustrated in figure 2, the first layer quality 5 should compulsorily be positioned adjacently to the second layer quality 5', whereby guaranteeing that the coating layers 5,5' are interspersed without repetition.

Alternatively, however, it is possible to conceive a ring 1 according to the teachings of the present invention in which there may be two adjacent layers of the same quality, depending on the resistance and ductility qualities desired for the coating 3.

As can clearly be seen in figure 2, the coating 3 of the preferred embodiment of the ring 1 comprises eight layers of chromium nitride 5,5', where the qualities of the coating layers 5,5' are interspersed without repetition.

If necessary or desirable, the layers 5,5' may comprise one or more additional chemical elements, in varied proportions and calculated based on the mechanical property sought.

Preferably, the additional chemical elements, if present, are those selected from among the group comprised of oxygen (O) or carbon (C) in a percentage not higher than 10% in mass.

These chemical elements may be present, within the highlighted range, in at least one of the layers 5,5', in some or all of them, based on the mechanical properties of the coating desirable.

With the present coating 3, comprised by a plurality of layers of CrN and Cr₂N, it is possible to achieve piston ring that presents improved performance/behavior in more critical operating situations, due to the fact that it presents better wear-resistance properties and, at the same time, a considerable reduction in the internal stress rates.

With the use of the coating 3, the resulting ring presents a reduction in the internal stress rates of about 50%, translating into a much greater resistance to the spalling phenomenon, in which small portions of the coating flake off due to the occurrence of micro-cracks owing to the accumulation of tension and low ductility. The major technical structural drawback is that the spalling tends to occur in certain parts of the ring, whereas in other parts the coating remains intact or hardly damaged even at the end of the useful life of the part.

This reduction in the internal stress rates brings with it the advantages of enabling an increase in adhesion energy of the layers between themselves and a reduction in the thickness of the coating, which is possible because of the large reduction in spalling and it is possible to guarantee that even with a reduced thickness there will be a coating 3 throughout the entire operating life of the ring.

The various layers 5,5' of the coating 3 are applied by a process known in the art as physical vapor deposition (PVD).

PVD involves purely physical processes, such as high temperature, vacuum evaporation or plasma pumping. Additionally, it is possible to add a gas, such as, for example, Nitrogen (N₂), such that it combines with the metallic material that is being deposited and forms nitrides, which is the specific case of the present invention. Among the processes used to evaporate the metallic material of the source (target cathode), one of the most well-known is the cathode arc, where a high potency electric arc is directed towards the material source, evaporating it and generating ions that are deposited on the desired surface of a part (i.e., a ring). In the presence of gases such as nitrogen, the nitride from the metallic material is deposited on the part.

In other words, the process of deposition by cathode arc, or PVD-Arc is a technique of physical vapor deposition where an electric arc is used to vaporize material of a target cathode. The vaporized material then condenses on a substrate, forming a fine film.

Essentially, the pressure control of the nitrogen gas (N₂) enables the production of the layers 5,5' sequentially. The layers composed of CrN have a percentage of nitrogen atoms between 22% and 25% by weight, whereas in the layers composed of Cr₂N, the percentage of nitrogen atoms is between 12% and 16% by weight.

In the case of the coating 3 of the present invention, in the two chromium nitride phases, the greatest hardness is obtained with the composition Cr₂N and the greatest ductility, in turn, is achieved by the use of the composition CrN. The combination of these two compositions in the form of layers 5,5' as mentioned above brings surprising advantages, chiefly in terms of the benefit provided to the coating 3 as a whole owing to its superior capacity to absorb internal stress. The layers 5 of CrN, more ductile, absorb the efforts and deform, decreasing the deformation forces to which the more rigid layers 5' of Cr₂N are subjected, resulting in a decrease trend of the appearance of micro-cracks therein. The result is a considerable increase in the performance of the ring.

Further, since a greater hardness is obtained with the layer of Cr₂N, it is possible to reduce the thickness of the coating without prejudice to the resistance to wear.

The preferred embodiment of the ring 1, illustrated in figure 2, presents a surface hardness of the order of 1700 to 2500 HV, preferably about 2100 HV, with an inner stress of -1000 N/mm². Preferably, the thickness of the coating (3) presents rates in the range of 10 to 60 microns, that is, it has a highly reduced thickness (nanolayer).

Optionally, there may be provided an adhesion layer composed of chrome, nickel or cobalt positioned between the base 2 and the coating 3.

Additionally, a 'Scratch Test' was carried out to appraise the resistance to delamination of the coating. The result of this test is achieved by applying a Normal Force to a substrate-coating system at the same time in which the sample is moved at a constant speed. The lowest load at which the first fault occurs is called the Critical Load (Lc). The equipment used provides data for cross referencing of the critical load while at the same time recording the effects of: tangential force variation, indenter penetration depth and acoustic emittance detection. The microscope analysis of each risk is carried out after the test to confirm the occurrence of the fault. The higher the load in which the fault occurs, the more resistant the coating is against delamination.

In the scratch tests, which measure the resistance of the coating to delamination, the first delamination was only achieved by applying a load of 29N, considerably superior to the load limit of 17N supported by a ring of the state of the art having a monolayer coating of CrN/Cr2N.

Preferably, the coating 3 is applied over the entire surface of the ring 1, but there is nothing to prevent it from being application to certain parts, partially removed or even applying another quality of coating over it. The piston ring thus arranged is still included within the scope of protection of the claims.

Having described examples of preferred embodiments, it must be understood that the scope of the present invention encompasses other possible variations, and is only limited by the content of the claims appended hereto, potential equivalents being included therein.

## Claims

1. Piston ring, particularly for use in internal combustion engines or compressors, comprising at least a metallic base (2) to which there is applied, by the process of physical vapor deposition (PVD), a coating (3) of chromium nitride, **characterized in that** the coating (3) comprises a periodicity (P), formed by at least two adjacent layers (5,5'), each layer (5,5') having a predominantly chromium nitride phase different from the adjacent layer.

2. Ring according to claim 1, **characterized in that** the predominantly chromium nitride phases may present a predominantly CrN or Cr₂N constitution.

3. Ring according to claim 2, **characterized in that** each periodicity (P) is comprised by only two adjacent layers (5,5'), each with its predominantly chromium nitride phase.

4. Ring according to claim 1, 2 or 3, **characterized in that** the plurality of layers (5,5') contains an additional chemical element selected from among the group comprising of oxygen or carbon in a percentage not higher than 10% in mass.

5. Ring according to claim 1, **characterized in that** the Vickers hardness of the coating presents rates between 1,700 and 2,500 HV.

6. Ring according to claim 1, **characterized in that** the thickness of the coating (3) presents rates in the range of 10 to 60 microns.

7. Ring according to claim 6, **characterized in that** the coating (3) is a nanolayer.

8. Ring according to claim 1, **characterized in that** the base (2) is composed of steel with 10 to 17% of chrome.

9. Ring according to claim 1, **characterized in that** the base (2) is composed of cast iron.

10. Ring according to claim 8, **characterized in that** n the steel that constitutes the base (2) undergoes a nitriding process.

11. Ring according to claim 1, **characterized in that** there is provided an adhesion layer composed of chrome, nickel or cobalt positioned between the base (2) and the coating (3).

## Patentansprüche

1. Kolbenring, insbesondere zur Verwendung in Motoren mit innerer Verbrennung oder Kompressoren, umfassend mindestens eine metallische Basis (2), auf welche durch das Verfahren von physikalischer Gasphasen-Abscheidung (PVD) eine Beschichtung (3) aus Chromnitrid aufgetragen wird, **dadurch gekennzeichnet, dass** die Beschichtung (3) eine Periodizität (P), gebildet durch mindestens zwei benachbarte Schichten (5,5'), umfasst, wobei jede Schicht (5,5') eine vorherrschende Chromnitridphase aufweist, die sich von der benachbarten Schicht unterscheidet.

2. Ring nach Anspruch 1, **dadurch gekennzeichnet, dass** die vorherrschenden Chromnitridphasen einen vorherrschenden CrN oder Cr₂N Aufbau aufweisen können.

3. Ring nach Anspruch 2, **dadurch gekennzeichnet, dass** jede Periodizität (P) nur zwei benachbarte Schichten (5,5'), jede mit ihrer vorherrschenden Chromnitridphase, umfasst.

4. Ring nach Anspruch 1, 2 oder 3, **dadurch gekennzeichnet, dass** die Vielzahl von Schichten (5,5') ein zusätzliches chemisches Element, ausgewählt aus der Gruppe, umfassend Sauerstoff oder Kohlenstoff in einem Prozentsatz von nicht höher als 10 Masse-%, enthält.

5. Ring nach Anspruch 1, **dadurch gekennzeichnet, dass** die Vickers-Härte der Beschichtung Werte zwischen 1 700 und 2 500 HV aufweist.

6. Ring nach Anspruch 1, **dadurch gekennzeichnet, dass** die Dicke der Beschichtung (3) Raten in dem Bereich von 10 bis 60 Mikrometern aufweist.

7. Ring nach Anspruch 6, **dadurch gekennzeichnet, dass** die Beschichtung (3) eine Nanoschicht ist.

8. Ring nach Anspruch 1, **dadurch gekennzeichnet, dass** die Basis (2) aus Stahl mit 10 bis 17 % Chrom besteht.

9. Ring nach Anspruch 1, **dadurch gekennzeichnet, dass** die Basis (2) aus Gusseisen besteht.

10. Ring nach Anspruch 8, **dadurch gekennzeichnet, dass** der Stahl, der die Basis (2) ausmacht, einem Nitrierungs-Verfahren unterzogen worden ist.

11. Ring nach Anspruch 1, **dadurch gekennzeichnet, dass** eine Haftschicht, bestehend aus Chrom, Nickel oder Cobalt, vorgesehen ist, die sich zwischen der Basis (2) und der Beschichtung (3) befindet.

## Revendications

1. Segment de piston, en particulier pour utilisation dans des moteurs à combustion interne ou des compresseurs, comprenant au moins une base métallique (2) à laquelle est appliqué, par le processus de dépôt en phase vapeur physique (PVD), un revêtement (3) de nitrure de chrome, **caractérisé en ce que** le revêtement (3) comprend une périodicité (P) formée par au moins deux couches adjacentes (5, 5'), chaque couche (5, 5') ayant de manière prédominante une phase de nitrure de chrome différente de la couche adjacente.

2. Segment selon la revendication 1, **caractérisé en ce que** les phases constituées de manière prédominante de nitrure de chrome peuvent présenter une constitution prédominante de CrN ou Cr₂N.

3. Segment selon la revendication 2, **caractérisé en ce que** chaque périodicité (P) est constituée par seulement deux couches adjacentes (5, 5'), chacune avec sa constitution prédominante de phase de nitrure de chrome.

4. Segment selon la revendication 1, 2 ou 3, **caractérisé en ce que** la pluralité de couches (5, 5') comprennent un élément chimique supplémentaire choisi dans le groupe constitué de l'oxygène ou du carbone dans un pourcentage qui n'est pas supérieur à 10 % en masse.

5. Segment selon la revendication 1, **caractérisé en ce que** la dureté Vickers du revêtement présente des taux compris entre 1700 et 2500 HV.

6. Segment selon la revendication 1, **caractérisé en ce que** l'épaisseur du revêtement (3) présente des taux dans la plage de 10 à 60 micromètres.

7. Segment selon la revendication 6, **caractérisé en ce que** le revêtement (3) est une nanocouche.

8. Segment selon la revendication 1, **caractérisé en ce que** la base (2) est composée d'acier avec 10 à 17 % de chrome.

9. Segment selon la revendication 1, **caractérisé en ce que** la base (2) est constituée de fonte de fer.

10. Segment selon la revendication 8, **caractérisé en ce que** l'acier qui constitue la base (2) subit un processus de nitruration.

11. Segment selon la revendication 1, **caractérisé en ce qu'**il est prévu une couche d'adhérence composée de chrome, de nickel ou de cobalt positionnée entre la base (2) et le revêtement (3).
